# DEMANDE DE BREVET EUROPEEN

(11) **EP 4 199 122 A1**
(43) Date de publication de la demande: **21.06.2023**
(21) Numéro de dépôt: 22214004.8
(22) Date de dépôt: 15.12.2022
(51) Int. Cl.: H01L 31/0747, H01L 31/18

(54) **CELLULE PHOTOVOLTAÏQUE A CONTACTS PASSIVES ET A REVÊTEMENT ANTIREFLET**

(30) Priorité: 16.12.2021 FR 2113720
(71) Demandeur: Commissariat à l'énergie atomique et aux énergies alternatives, 75015 Paris (FR)
(72) Inventeur: FAVRE, Wilfried, 38054 GRENOBLE CEDEX 09 (FR); DANEL, Adrien, 38054 GRENOBLE CEDEX 09 (FR); JAY, Frédéric, 38054 GRENOBLE CEDEX 09 (FR)
(74) Mandataire: Brevalex

(57) **Abrégé**

Cellule photovoltaïque (100) comprenant :
- un ensemble comprenant un substrat (102), des première et deuxième couches de passivation (106, 110) recouvrant des faces opposées du substrat et également des faces latérales (116) du substrat, et des première et deuxième couches collectrices de charges (104, 108) ;
- une première couche de TCO (118) disposée contre la première face principale de l'ensemble et telle que des bords (120) de la première face principale de l'ensemble ne soient pas recouverts par la première couche de TCO;
- une deuxième couche de TCO (122) recouvrant la totalité de la deuxième face principale de l'ensemble ;
- un revêtement antireflet (128) recouvrant en partie les première et/ou deuxième couches collectrices de charges du côté des faces latérales du substrat et non recouvertes par la deuxième couche de TCO, et recouvrant également les bords de la première face principale.

## Description

### DOMAINE TECHNIQUE

L'invention concerne le domaine des cellules photovoltaïques à contacts passivés. L'invention concerne avantageusement une cellule photovoltaïque à hétérojonction, ou une cellule photovoltaïque de type TOPCon (« Tunnel Oxide Passivated Contact» en anglais, ou à contacts passivés par oxyde tunnel), ou une cellule photovoltaïque de type tandem sur semi-conducteur par exemple à structure pérovskite sur silicium (PK/Si).

### ÉTAT DE LA TECHNIQUE ANTERIEURE

Dans le domaine des cellules photovoltaïques comprenant un absorbeur (correspondant à la plaquette ou au « wafer » utilisé) en semi-conducteur cristallin, les meilleurs rendements sont obtenus pour les technologies dites à contacts passivés. Une cellule à contacts passivés comporte une ou plusieurs couches minces interposées entre les métallisations et l'absorbeur et qui permettent d'éviter un contact direct entre les métallisations et l'absorbeur. Cela permet de limiter fortement les recombinaisons de porteurs de charges générés sous éclairement et d'atteindre des tensions de circuit-ouvert bien plus élevées que les autres technologies avec contacts directs métallisations - absorbeur, sur la surface entière ou localisés sur une partie de la surface de l'absorbeur (AI-BSF, PERC).

Pour assurer le transport latéral des charges de l'absorbeur vers les métallisations, il convient d'utiliser des couches transparentes et conductrices, car le transport de ces charges par l'absorbeur seul ne suffit généralement pas. Ces couches servent à la fois de couches antireflets et de couches de transport latéral des charges, notamment sur la face de collection des porteurs minoritaires (c'est-à-dire les trous dans le cas d'un absorbeur en silicium cristallin dopé négativement). Ces couches correspondent à des couches de TCO (« Transparent Conductive Oxide » en anglais, ou oxyde transparent conducteur), et avantageusement d'ITO (oxyde d'indium et d'étain).

Lors de la réalisation de la cellule, les couches de TCO sont déposées du côté de la face avant (qui est la face exposée au rayonnement lumineux direct) et de la face arrière de la cellule. Du matériau de ces couches de TCO se retrouve toutefois sur les flancs latéraux, ou face latérales, de la cellule. Or, sur ces faces latérales, il convient d'éviter un chevauchement des couches de TCO avant et arrière pour éviter la formation de courts-circuits entre les parties dopées n et p de la cellule.

Pour éviter un tel chevauchement, le document Janke et al., « Quantifying & Reducing Edge Losses in Silicon Heterojunction Solar Cells », 36th European Photovoltaic Solar Energy Conférence and Exhibition, 2CO.11.2, propose de recouvrir les bords de la face arrière d'une cellule à hétérojonction à émetteur inversé (jonction formée du côté de la face arrière de la cellule) par un masque lors du dépôt de la couche de TCO arrière. La présence de ce masque permet d'éviter le dépôt de TCO sur les bords de la face arrière de la cellule et éviter ainsi un contact avec la couche de TCO avant au niveau des faces latérales de la cellule. Néanmoins, cette technique entraîne le non recouvrement d'une partie de la face arrière de la cellule par le TCO, ce qui pénalise les performances de la cellule dans le cas d'une cellule à émetteur inversé. Ce document décrit également que le masquage des bords de la face avant de la cellule entraîne la création de courts-circuits entre les faces avant et arrière de la cellule. De plus, ne pas recouvrir toute la face avant de la cellule par du TCO est, dans le cas décrit dans ce document, problématique étant donné que cela réduit la surface de la cellule exposée à la lumière directe et qui est recouverte par une couche antireflets.

Les problèmes décrits ci-dessus pour une cellule photovoltaïque à hétérojonction se retrouvent également pour des cellules photovoltaïques de type TOPCon ou de type tandem sur semi-conducteur.

### EXPOSÉ DE L'INVENTION

Un but de la présente invention est de proposer une cellule photovoltaïque à absorbeur de semi-conducteur cristallin et à contacts passivés, dans laquelle les courts-circuits entre les parties dopées p et n de la cellule sont évités, et dont les performances soient peu pénalisées par le non-recouvrement d'une partie de la cellule par le TCO, en limitant notamment les pertes optiques au sein de la cellule.

Pour cela, la présente invention propose une cellule photovoltaïque comprenant au moins :
- un ensemble comprenant au moins une jonction p-n incluant au moins un substrat de semi-conducteur cristallin dopé selon un premier type de conductivité, des première et deuxième couches de passivation recouvrant respectivement des première et deuxième faces principales opposées du substrat et chacune recouvrant également des faces latérales du substrat, une première couche collectrice de charges configurée pour extraire et collecter des charges du premier type de conductivité et disposée contre la première couche de passivation, et une deuxième couche collectrice de charges configurée pour extraire et collecter des charges d'un deuxième type de conductivité, opposé au premier type de conductivité, et disposée contre la deuxième couche de passivation, ledit ensemble comprenant en outre une première face principale disposée du côté de la première face principale du substrat et une deuxième face principale disposée du côté de la deuxième face principale du substrat ;
- une première couche d'oxyde transparent conducteur disposée contre une partie de la première face principale de l'ensemble et telle que des bords de la première face principale de l'ensemble ne soient pas recouverts par la première couche d'oxyde transparent conducteur ;
- une deuxième couche d'oxyde transparent conducteur recouvrant la totalité de la deuxième face principale de l'ensemble et recouvrant partiellement des premières parties de la première couche collectrice de charges et/ou de la deuxième couche collectrice de charges disposées du côté des faces latérales du substrat ;
- des contacts électriquement conducteurs disposés contre les première et deuxième couches d'oxyde transparent conducteur ;
- un revêtement antireflet recouvrant au moins partiellement des deuxièmes parties de la première couche collectrice de charges et/ou de la deuxième couche collectrice de charges disposées du côté des faces latérales du substrat et non recouvertes par la deuxième couche d'oxyde transparent conducteur, et recouvrant également les bords de la première face principale.

Dans cette cellule, il est proposé de réaliser des première et deuxième couches d'oxyde transparent conducteur telles que du côté de la deuxième couche collectrice de charges, la deuxième couche d'oxyde transparent conducteur recouvre entièrement la deuxième face principale de l'ensemble comportant la jonction p-n, ce qui permet de maximiser la collecte des charges minoritaires de ce côté de la cellule. Du côté de la première couche collectrice de charges, une bonne conduction latérale des charges vers les deuxièmes contacts électriquement conducteurs est obtenue dans cette cellule.

De plus, du côté de la première couche collectrice de charges, des bords de la première face principale ne sont pas recouverts par la première couche d'oxyde transparent conducteur, afin de garantir l'absence de court-circuit au sein de la cellule.

En outre, il est proposé d'ajouter un revêtement antireflet recouvrant au moins partiellement des parties des couches collectrices de charges se trouvant contre les faces latérales du substrat et qui ne sont pas recouvertes par la deuxième couche d'oxyde transparent conducteur, et recouvrant également les bords de la première face principale. L'ajout de ce revêtement antireflet permet de limiter les pertes de courant liées au non recouvrement des bords par la première couche d'oxyde transparent conducteur (qui engendre des pertes optiques) grâce à un confinement optique obtenu grâce au revêtement antireflet.

Selon un mode de réalisation avantageux, le substrat de la cellule photovoltaïque correspond à un wafer de silicium cristallin de type n, et la cellule est de type à émetteur inversé (couche de conductivité opposée à celle du substrat disposée du côté de la cellule ne recevant pas de rayonnement direct).

En outre, lorsque le revêtement antireflet comporte un matériau diélectrique, ce revêtement antireflet peut contribuer à garantir l'absence de court-circuit entre les couches de conductivités différentes de la cellule.

Dans tout le document, la ou les faces appelées «faces principales» d'un élément désignent les faces de plus grandes dimensions de cet élément.

Les faces latérales du substrat peuvent être perpendiculaires aux faces principales du substrat.

Le revêtement antireflet peut recouvrir en outre la première couche d'oxyde transparent conducteur et les contacts électriquement conducteurs disposés contre la première couche d'oxyde transparent conducteur.

Le revêtement antireflet peut être diélectrique et peut recouvrir en outre au moins partiellement la deuxième couche d'oxyde transparent conducteur et les contacts électriquement conducteurs disposés contre la deuxième couche d'oxyde transparent conducteur.

Les bords de la première face principale peuvent former, dans un plan parallèle à la première face principale, un contour de largeur inférieure ou égale à 500 µm. De manière avantageuse, cette largeur peut être comprise entre 100 µm et 500 µm.

Le revêtement antireflet peut comporter au moins l'un des matériaux suivants : nitrure de silicium, oxyde de silicium, oxynitrure de silicium, oxyde de zinc dopé aluminium.

Le revêtement antireflet peut comporter un indice de réfraction dont la valeur est comprise entre celle de l'indice de réfraction de la première couche d'oxyde transparent conducteur et celle d'un matériau d'encapsulation de la cellule photovoltaïque.

Le revêtement antireflet peut former une couche d'épaisseur comprise entre 5 nm et 100 nm.

Le semi-conducteur du substrat et des première et deuxième couches collectrices de charges peut comporter du silicium.

Dans une première configuration, la cellule photovoltaïque peut être une cellule à hétérojonction, et :
- les première et deuxième couches de passivation peuvent comporter du semi-conducteur amorphe, ou nanocristallin, ou microcristallin, et non dopé intentionnellement, et
- les première et deuxième couches collectrices de charges peuvent comporter du semi-conducteur amorphe, ou nanocristallin, ou microcristallin, dopé.

Dans une deuxième configuration, la cellule photovoltaïque peut être une cellule de type TOPCon, et :
- les première et deuxième couches de passivation peuvent correspondre à des couches d'oxyde tunnel, et
- les première et deuxième couches collectrices de charges peuvent comporter du semi-conducteur polycristallin dopé.

Dans une troisième configuration, la cellule photovoltaïque peut être de type tandem sur semi-conducteur, et :
- le substrat, les première et deuxième couches de passivation et les première et deuxième couches collectrices de charges peuvent former une cellule inférieure de la cellule photovoltaïque, une face principale de la cellule inférieure pouvant former la deuxième face principale dudit ensemble ;
- ledit ensemble peut comporter en outre une cellule supérieure disposée sur la cellule inférieure, une face principale de la cellule supérieure pouvant former la première face principale dudit ensemble.

La cellule supérieure peut comporter au moins une couche de matériau de structure pérovskite.

L'invention concerne également un procédé de réalisation d'une cellule photovoltaïque, comportant la mise en œuvre des étapes suivantes :
- réalisation d'un ensemble comprenant au moins une jonction p-n incluant au moins un substrat de semi-conducteur cristallin dopé selon un premier type de conductivité, des première et deuxième couches de passivation recouvrant respectivement des première et deuxième faces principales opposées du substrat et chacune recouvrant également des faces latérales du substrat, une première couche collectrice de charges configurée pour extraire et collecter des charges du premier type de conductivité et disposée contre la première couche de passivation, et une deuxième couche collectrice de charges configurée pour extraire et collecter des charges d'un deuxième type de conductivité, opposé au premier type de conductivité, et disposée contre la deuxième couche de passivation, ledit ensemble comprenant en outre une première face principale disposée du côté de la première face principale du substrat et une deuxième face principale disposée du côté de la deuxième face principale du substrat ;
- réalisation d'une première couche d'oxyde transparent conducteur disposée contre une partie de la première face principale de l'ensemble et telle que des bords de la première face principale de l'ensemble ne soient pas recouverts par la première couche d'oxyde transparent conducteur ;
- réalisation d'une deuxième couche d'oxyde transparent conducteur recouvrant la totalité de la deuxième face principale de l'ensemble et recouvrant partiellement des premières parties de la première couche collectrice de charges et/ou de la deuxième couche collectrice de charges disposées du côté des faces latérales du substrat ;
- réalisation de contacts électriquement conducteurs disposés contre les première et deuxième couches d'oxyde transparent conducteur ;
- réalisation d'un revêtement antireflet recouvrant au moins partiellement des deuxièmes parties de la première couche collectrice de charges et/ou de la deuxième couche collectrice de charges disposées du côté des faces latérales du substrat et non recouvertes par la deuxième couche d'oxyde transparent conducteur, et recouvrant également les bords de la première face principale.

Dans une configuration particulière :
- les étapes du procédé peuvent former plusieurs cellules photovoltaïques ;
- le procédé peut comporter en outre une étape d'interconnexion électrique des cellules photovoltaïques entre elles, mise en œuvre entre la réalisation des contacts électriquement conducteurs des cellules et la réalisation du revêtement antireflet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 6 représentent des cellules photovoltaïques à hétérojonctions à contacts passivés et à revêtement antireflet, objet de la présente invention, selon différents modes de réalisation ;
- la figure 7 représente une cellule photovoltaïque de type tandem sur semi-conducteur et à revêtement antireflet, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DETAILLÉ DE MODES DE REALISATION PARTICULIERS

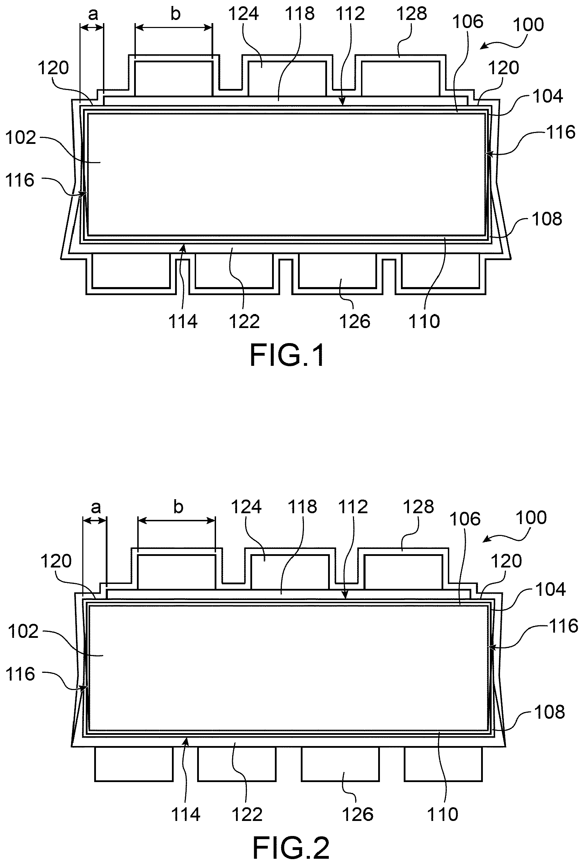

Une cellule photovoltaïque 100 selon un premier mode de réalisation est décrite ci-dessous en lien avec la figure 1. Dans cet exemple, la cellule 100 est une cellule à hétérojonction.

La cellule 100 comporte au moins une jonction p-n incluant un absorbeur formé par un substrat 102 de semi-conducteur cristallin dopé selon un premier type de conductivité. Dans l'exemple de réalisation décrit ici, le substrat 102 comporte du silicium cristallin dopé n.

La cellule 100 comporte une première couche collectrice de charges 104 configurée pour extraire et collecter des charges du premier type de conductivité (des électrons dans l'exemple décrit ici). Selon un exemple de réalisation, la première couche collectrice de charges 104 comporte du semi-conducteur amorphe (du silicium amorphe hydrogéné dans cet exemple), dopé selon le premier type de conductivité (dopé n dans cet exemple).

La cellule 100 comporte également une première couche de passivation 106 recouvrant une première face principale du substrat 102 telle que la première couche de passivation 106 soit disposée entre cette première face principale du substrat 102 et la première couche collectrice de charges 104. Dans cet exemple de réalisation, la première couche de passivation 106 comporte du semi-conducteur amorphe (du silicium amorphe hydrogéné dans cet exemple), non dopé intentionnellement.

La cellule 100 comporte également une deuxième couche collectrice de charges 108 configurée pour extraire et collecter des charges du deuxième type de conductivité (des trous dans l'exemple décrit ici). Selon un exemple de réalisation, la deuxième couche collectrice de charges 108 comporte du semi-conducteur amorphe (du silicium amorphe hydrogéné dans cet exemple) dopé selon le deuxième type de conductivité (dopé p dans cet exemple).

La cellule 100 comporte également une deuxième couche de passivation 110 recouvrant une deuxième face principale du substrat 102 telle que la deuxième couche de passivation 110 soit disposée entre cette deuxième face principale du substrat 102 et la deuxième couche collectrice de charges 108. Dans cet exemple de réalisation, la deuxième couche de passivation 110 comporte du semi-conducteur amorphe (du silicium amorphe hydrogéné dans cet exemple) non dopé intentionnellement.

Les couches 104, 106, 108 et 110 ont par exemple chacune une épaisseur comprise entre 2 nm et 20 nm, et avantageusement inférieure à 15 nm.

Le substrat 102 et les couches 104, 106, 108 et 110 forment un ensemble doté d'une première face principale 112 disposée du côté de la première face principale du substrat 102 et d'une deuxième face principale 112 opposée et disposée du côté de la deuxième face principale du substrat 102. Dans l'exemple de réalisation décrit ici, les première et deuxième faces principales 112, 114 sont formées respectivement par les surfaces des première et deuxième couches collectrices de charges 104, 108 opposées à celles en contact avec les première et deuxième couches de passivation 106, 110.

Selon un exemple de la réalisation de la cellule 100, la première couche de passivation 106 et la première couche collectrice de charges 104 sont tout d'abord déposées du côté de la première face principale du substrat 102. La mise en œuvre de ces dépôts engendre un dépôt de portions de ces premières couches 104, 106 contre au moins une partie des faces latérales 116 du substrat 102. La deuxième couche de passivation 110 et la deuxième couche collectrice de charges 110 sont ensuite déposées du côté de la deuxième face principale du substrat 102, opposée à la première face principale du substrat 102. La mise en œuvre de ces dépôts engendre un dépôt de portions de ces deuxièmes couches 108, 110 contre les éventuelles parties des faces latérales 116 du substrat 102 non recouvertes par les premières couches 104, 106, et éventuellement contre une partie des portions des premières couches 104, 106 localisées contre les faces latérales 116 du substrat 102. Les couches 104, 106, 108 et 110 sont par exemple déposées par PECVD (dépôt chimique en phase vapeur assisté par plasma) ou HWCVD (dépôt chimique en phase vapeur assisté par filament chaud).

La cellule 100 comporte également une première couche d'oxyde transparent conducteur (TCO) 118 disposée contre une partie de la première face principale 112. En outre, la forme de la première couche de TCO 118 est telle que des bords 120 de la première face principale 112 ne soient pas recouverts par la première couche de TCO 118. Ce non-recouvrement des bords 120 de la première face principale 112 par la première couche de TCO 118 est par exemple obtenu en mettant en œuvre un dépôt de la première couche de TCO 118 à travers un élément masquant les bords 120. Cet élément masquant correspond par exemple au support sur lequel la cellule 100 est disposée lors du dépôt de la première couche de TCO 118.

Dans l'exemple de réalisation décrit ici, les bords 120 de la première face principale 112 forment, dans un plan parallèle à la première face principale 112, un contour de largeur (dimension référencée « a » sur la figure 1) inférieure ou égale à 500 µm, et par exemple comprise entre 100 µm et 500 µm.

La cellule 100 comporte également une deuxième couche de TCO 122 recouvrant la totalité de la deuxième face principale 114 et recouvrant également au moins des premières parties de la première couche collectrice de charges 104 et/ou de la deuxième couche collectrice de charges 108 disposées du côté des faces latérales 116 du substrat 102. Dans l'exemple de la figure 1, la deuxième couche de TCO 122 recouvre la totalité de la deuxième face principale 114 ainsi qu'une partie des portions de la deuxième couche collectrice de charges 108 disposées du côté des faces latérales 116 du substrat 102.

De manière avantageuse, le TCO des couches 118, 122 correspond à de l'oxyde d'indium et d'étain (ITO). En outre, le matériau de la première couche de TCO 118 peut être identique ou différent du matériau de la deuxième couche de TCO 122. L'épaisseur de chacune des couches de TCO 118, 122 est par exemple comprise entre 5 nm et 100 nm. Cette épaisseur de chacune des couches de TCO 118, 122 est avantageusement constante. Les couches de TCO 118, 122 sont par exemple déposées par pulvérisation cathodique (« sputtering » en anglais), ou par PVD (dépôt physique en phase vapeur), ou par PLD (dépôt par ablation laser pulsée).

La cellule 100 comporte également des premiers contacts électriquement conducteurs 124 disposés contre la première couche de TCO 118 et des deuxièmes contacts électriquement conducteurs 126 disposés contre la deuxième couche de TCO 122. Ces contacts électriquement conducteurs 124, 126 comportent avantageusement au moins un matériau métallique tel que de l'argent, du cuivre ou de l'aluminium. Ces contacts électriquement conducteurs 124, 126 correspondent aux doigts de métallisation de la cellule 100 ainsi qu'au busbars de la cellule 100 (sur la figure 1, seuls les doigts de métallisation sont représentés). A titre d'exemple, la largeur (portant la référence « b » sur la figure 1) de chacun de ces doigts de métallisation est par exemple comprise entre 30 µm et 50 µm, leur épaisseur est par exemple de l'ordre de 8 µm.

Enfin, la cellule 100 comporte un revêtement antireflet 128 recouvrant au moins des deuxièmes parties de la première couche collectrice de charges 104 et/ou de la deuxième couche collectrice de charges 108 disposées contre du côté des faces latérales 116 du substrat 102 et non recouvertes par la deuxième couche de TCO 122, et recouvrant également les bords 120 de la première face principale 112. Dans le premier mode de réalisation décrit en lien avec la figure 1, le revêtement 128 recouvre également :
- la première couche de TCO 118 et les premiers contacts électriquement conducteurs 124 disposés contre la première couche de TCO 118, et
- la deuxième couche de TCO 122 et les deuxièmes contacts électriquement conducteurs 126 disposés contre la deuxième couche de TCO 122.

Dans ce premier mode de réalisation, le revêtement antireflet 128 forme une enveloppe entourant l'ensemble des différents éléments de la cellule 100. Ainsi, le revêtement antireflet 128 forme également une couche barrière à l'humidité.

L'épaisseur du revêtement antireflet 128 est par exemple comprise entre 5 nm et 100 nm.

Du fait que, dans ce premier mode de réalisation, le revêtement antireflet 128 est en contact avec les premières et deuxièmes couches collectrices de charges 104, 108 et avec la deuxième couche de TCO 122, le matériau du revêtement antireflet 128 est diélectrique.

Le revêtement antireflet 128 comporte par exemple du nitrure de silicium, par exemple sous la forme de SiN ou sous une autre forme stœchiométrique, et/ou d'oxyde de silicium, par exemple sous la forme de SiO₂ ou sous une autre forme stœchiométrique.

En outre, afin que le revêtement antireflet 128 présente de bonnes propriétés optiques, le matériau du revêtement 128 peut être choisi tel qu'il comporte un indice de réfraction dont la valeur est comprise entre celle de l'indice de réfraction de la première couche de TCO 118 et celle d'un matériau d'encapsulation de la cellule 100, non visible sur la figure 1, recouvrant le revêtement 128.

Dans ce premier mode de réalisation, le revêtement antireflet 128 est par exemple déposé par ALD (« Atomic Layer Déposition » en anglais, ou dépôt de couche atomique), ce qui permet de déposer le revêtement 128 de tous les côtés de la cellule 100.

Une cellule photovoltaïque 100 selon un deuxième mode de réalisation est décrite ci-dessous en lien avec la figure 2.

Par rapport au premier mode de réalisation précédemment décrit, le revêtement antireflet 128 ne forme pas une enveloppe entourant l'ensemble des différents éléments de la cellule 100. En effet, dans ce deuxième mode de réalisation, le revêtement antireflet 128 recouvre :
- les deuxièmes parties de la première couche collectrice de charges 104 et/ou de la deuxième couche collectrice de charges 108 disposées du côté des faces latérales 116 du substrat 102 et non recouvertes par la deuxième couche de TCO 122, et
- les bords 120 de la première face principale 112, et
- la première couche de TCO 118 et les premiers contacts électriquement conducteurs 124.

Du fait que, dans ce deuxième mode de réalisation, le revêtement antireflet 128 est en contact avec les premières et deuxièmes couches collectrices de charges 104, 108 et avec la deuxième couche de TCO 122, le matériau du revêtement antireflet 128 est diélectrique.

Dans ce deuxième mode de réalisation, le revêtement antireflet 128 est par exemple déposé par PECVD (dépôt chimique en phase vapeur assisté par plasma) ou PVD (dépôt physique en phase vapeur), avec la cellule 100 disposée sur un support telle que la deuxième couche de TCO 122 se trouve du côté de ce support.

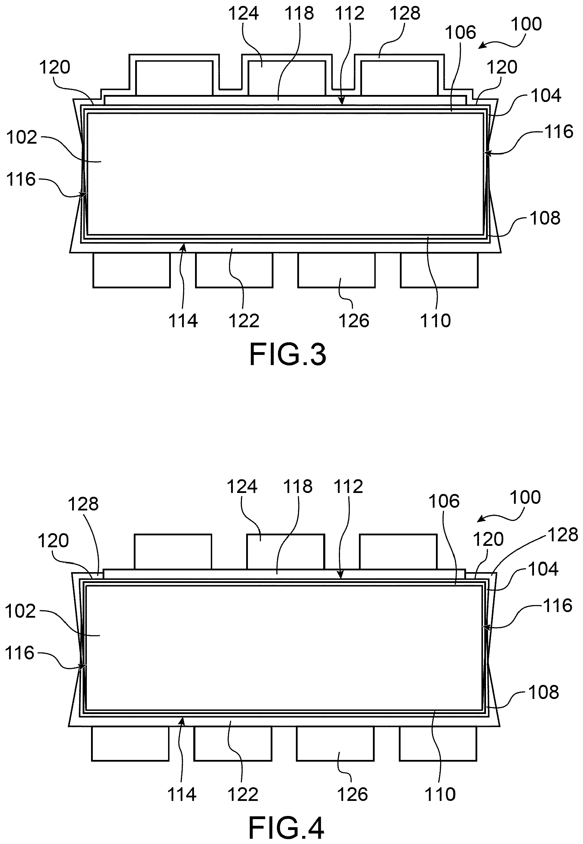

Une cellule photovoltaïque 100 selon un troisième mode de réalisation est décrite ci-dessous en lien avec la figure 3.

Comme dans le deuxième mode de réalisation précédemment décrit, le revêtement antireflet 128 ne forme pas une enveloppe entourant l'ensemble des différents éléments de la cellule 100. Par contre, dans ce troisième mode de réalisation, le revêtement antireflet 128 recouvre seulement :
- les deuxièmes parties de la première couche collectrice de charges 104 disposées du côté des faces latérales 116 du substrat 102 et les bords 120 de la première face principale 112, et
- la première couche de TCO 118 et les premiers contacts électriquement conducteurs 124 disposés contre la première couche de TCO 118.

Dans ce troisième mode de réalisation, le revêtement antireflet 128 n'est pas en contact avec la deuxième couche de TCO 122. Le matériau du revêtement antireflet 128 peut donc être diélectrique ou électriquement conducteur. Un tel matériau électriquement conducteur pouvant servir de revêtement antireflet 128 correspond par exemple à un TCO tel que de l'ITO ou bien encore à du ZnO:Al (oxyde de zinc dopé aluminium, ou AZO).

Dans ce troisième mode de réalisation, le revêtement antireflet 128 est par exemple déposé par PECVD (dépôt chimique en phase vapeur assisté par plasma) ou PVD (dépôt physique en phase vapeur), avec la cellule 100 disposée sur un support telle que la deuxième couche de TCO 122 se trouve du côté de ce support, et en masquant les deuxièmes parties de la deuxième couche collectrice de charges 108 disposées du côté des faces latérales 116 du substrat 102 et qui ne sont pas recouvertes par la deuxième couche de TCO 122.

Une cellule photovoltaïque 100 selon un quatrième mode de réalisation est décrite ci-dessous en lien avec la figure 4.

Comme dans les deuxième et troisième modes de réalisation précédemment décrits, le revêtement antireflet 128 ne forme pas une enveloppe entourant l'ensemble des différents éléments de la cellule 100. Par contre, dans ce quatrième mode de réalisation, le revêtement antireflet 128 recouvre :
- les deuxièmes parties des premières et deuxièmes couches collectrices de charges 104, 108 disposées du côté des faces latérales 116 du substrat 102 et non recouvertes par la deuxième couche de TCO 122, et
- les bords 120 de la première face principale 112.

Dans ce quatrième mode de réalisation, il est possible que le revêtement antireflet 128 soit en contact avec la deuxième couche de TCO 122. Ainsi, pour éviter tout risque de court-circuit, le matériau du revêtement antireflet 128 est de préférence diélectrique.

Dans ce quatrième mode de réalisation, le revêtement antireflet 128 est par exemple déposé par PECVD (dépôt chimique en phase vapeur assisté par plasma) ou PVD (dépôt physique en phase vapeur), avec la cellule 100 disposée sur un support telle que la deuxième couche de TCO 122 se trouve du côté de ce support, et en utilisant un élément masquant, lors du dépôt, la première couche de TCO 118.

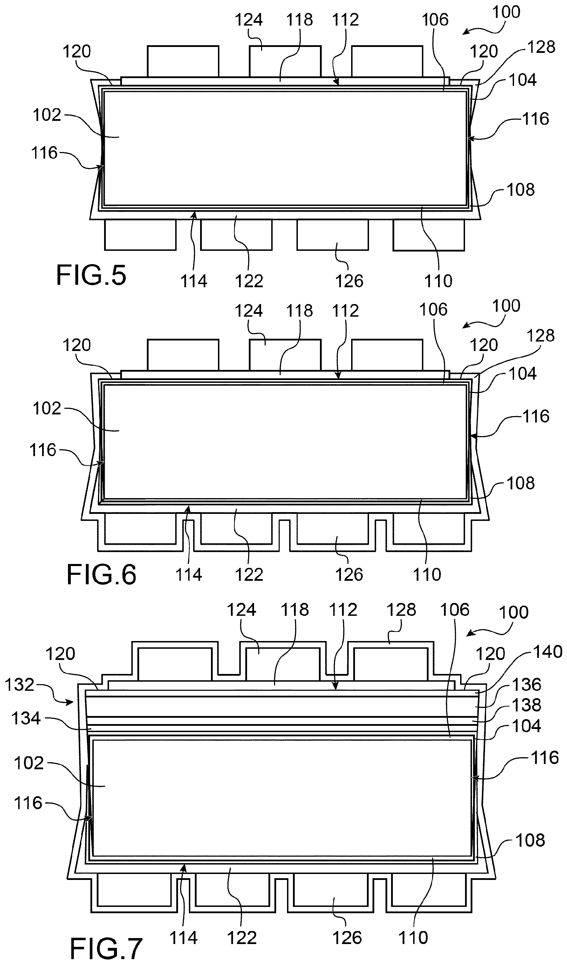

Une cellule photovoltaïque 100 selon un cinquième mode de réalisation est décrite ci-dessous en lien avec la figure 5.

Dans ce cinquième mode de réalisation, le revêtement antireflet 128 ne forme pas une enveloppe entourant l'ensemble des différents éléments de la cellule 100, et recouvre seulement les parties de la première couche collectrice de charges 104 disposées du côté des faces latérales 116 du substrat 102 et les bords 120 de la première face principale 112.

Dans ce cinquième mode de réalisation, le revêtement antireflet 128 est par exemple déposé par PECVD (dépôt chimique en phase vapeur assisté par plasma) ou PVD (dépôt physique en phase vapeur), avec la cellule 100 disposée sur un support telle que la deuxième couche de TCO 122 se trouve du côté de ce support, et en utilisant un élément masquant, lors du dépôt, la première couche de TCO 118 et les parties des portions de la deuxième couche collectrice de charges 108 disposées du côté des faces latérales 116 du substrat 102 et qui ne sont pas recouvertes par la deuxième couche de TCO 122. Comme dans le troisième mode de réalisation, le matériau du revêtement antireflet 128 peut être diélectrique ou électriquement conducteur.

Une cellule photovoltaïque 100 selon un sixième mode de réalisation est décrite ci-dessous en lien avec la figure 6.

Dans ce sixième mode de réalisation, le revêtement antireflet 128 ne forme pas une enveloppe entourant l'ensemble des différents éléments de la cellule 100, et recouvre :
- les deuxièmes parties des premières et deuxièmes couches collectrices de charges 104, 108 disposées du côté des faces latérales 116 du substrat 102 et les bords 120 de la première face principale 112, et
- la deuxième couche de TCO 122 et les deuxièmes contacts électriquement conducteurs 126 disposés contre la deuxième couche de TCO 122.

Dans ce sixième mode de réalisation, le revêtement antireflet 128 est par exemple déposé par PECVD (dépôt chimique en phase vapeur assisté par plasma) ou PVD (dépôt physique en phase vapeur). Il est par exemple possible de déposer tout d'abord le revêtement antireflet 128 du côté de la première face principale 112 tel qu'il recouvre seulement les parties des premières et deuxième couches collectrices de charges 104, 108 disposées du côté des faces latérales 116 du substrat 102 et les bords 120 de la première face principale 112, puis en effectuant un deuxième dépôt du côté de la deuxième face principale 114 afin d'aboutir à la configuration représentée sur la figure 6.

Des variantes des différents modes de réalisation précédemment décrits sont envisageables. Par exemple, en considérant le quatrième mode de réalisation précédemment décrit, il est possible que le revêtement antireflet 128 recouvre partiellement la première couche de TCO 118 et éventuellement certains des premiers contacts électriquement conducteurs 124.

Dans les différents exemples de réalisation précédemment décrits, le substrat 102 et la première couche collectrice de charges 104 comportent du semi-conducteur dopé de type n, et la deuxième couche collectrice de charges 108 comporte du semi-conducteur dopé p. En variante, pour les différents modes de réalisation précédemment décrits, il est possible que le substrat 102 et la première couche collectrice de charges 104 comportent du semi-conducteur dopé de type p, et que la deuxième couche collectrice de charges 108 comporte du semi-conducteur dopé n.

Dans les différents exemples de réalisation précédemment décrits, les couches de passivation 106, 110 et les couches collectrices de charges 104, 108 comportent du semi-conducteur amorphe. En variante, il est possible que ces couches 104, 106, 108 et 110 comportent du semi-conducteur microcristallin ou nanocristallin.

Dans les différents exemples de réalisation précédemment décrits, les cellules 100 sont de type à émetteur inversé, c'est-à-dire que les émetteurs des cellules (correspondant à la deuxième couche collectrice de charges 108) sont formés du côté des cellules 100 qui n'est pas destiné à recevoir directement de rayonnement lumineux. En variante, il est possible que les cellules 100 soient de type à émetteur standard, c'est-à-dire telles que les émetteurs des cellules soient formés du côté des cellules 100 destiné à recevoir un rayonnement lumineux direct.

Dans les différents exemples de réalisation précédemment décrits, la cellule 100 correspond à une cellule à hétérojonction formée grâce à un substrat de semi-conducteur cristallin et des couches minces de silicium amorphes (ou microcristallin ou nanocristallin) déposées sur ce substrat.

En variante de tous les modes de réalisation précédemment décrits, la cellule 100 peut correspondre à une cellule de type TOPCon. Dans ce cas, les couches de passivation 106, 110 correspondent à des couches d'oxyde tunnel comprenant par exemple du SiₓO_{y} et dont l'épaisseur est par exemple comprise entre 1 nm et 5 nm. Dans une telle cellule TOPCon, les première et deuxième couches collectrices de charges 104, 108 comportent du semi-conducteur (par exemple du silicium) polycristallin dopé (première couche collectrice de charges 104 dopée n et deuxième couche collectrice de charges dopée p 108 lorsque le substrat 102 comporte du semi-conducteur dopé n).

La figure 7 représente un autre mode de réalisation de la cellule photovoltaïque 100. Dans cet autre mode de réalisation, la cellule 100 est de type tandem sur semi-conducteur, et avantageusement à structure pérovskite sur silicium (PK/Si).

La cellule 100 selon cet autre mode de réalisation comporte le substrat 102, les première et deuxième couches de passivation 106, 110 et les première et deuxième couche collectrices de charges 104, 108 qui forment une cellule inférieure 130. Les caractéristiques du substrat 102 et des couches 104, 106, 108 et 110 (matériaux, épaisseurs, techniques de dépôt mises en œuvre pour les réaliser, etc.) sont par exemple similaires à celles précédemment décrites pour une cellule 100 à hétérojonction.

La cellule 100 selon cet autre mode de réalisation comporte également une cellule supérieure 132 disposée sur une couche de recombinaison 134 formée au préalable sur la cellule inférieure 130. La couche de recombinaison 134 comporte par exemple du TCO (ITO, AZO). La cellule supérieure 132 comporte une couche de matériau de structure pérovskite 136 comportant par exemple du CsₓFA₁₋ₓPb(I_{y}Br_{1-y})₃ et dont l'épaisseur est par exemple comprise entre 200 nm et 1 µm. La couche 136 est disposée entre une première couche collectrice de charges 138, qui comporte par exemple une monocouche auto-assemblée 2PACz, MeO-2PACz ou Me-4PACz telle que décrite dans le document WO 2019/207029 A1, et dont l'épaisseur est comprise entre 0,1 nm et 3 nm, et une deuxième couche collectrice de charges 140 comportant par exemple du fullerène (=C60) et du SnO₂ et dont l'épaisseur est par exemple comprise entre 0,1 nm et 30 nm. Les couches 134, 136, 138 et 140 sont par exemple réalisées par la mise en œuvre successive d'étapes de dépôt sur la cellule inférieure 130. D'autres détails de réalisation d'une telle cellule sont indiqués dans le document « Co-Evaporated Formamidinium Lead lodide Based Perovskites with 1000 h constant Stability for Fully Textured Monolithic Perovskite/Silicon Tandem Solar Cells » de Marcel Roß et al., Advanced Energy Materials, vol.11, Issue 35, 2021.

Dans la structure ainsi obtenue, une face principale de la cellule inférieure 130 (celle se trouvant du côté opposé à la cellule supérieure 132) forme la deuxième face principale 114, et une face principale de la cellule supérieure 132 (celle se trouvant du côté opposé à la cellule inférieure 130) forme la première face principale 112.

Comme dans les exemples de réalisation précédemment décrits, la cellule 100 comporte la première couche de TCO 118 disposée contre une partie de la première face principale 112 (sans recouvrir les bords 120), et la deuxième couche de TCO 122 recouvrant la totalité de la deuxième face principale 114 et recouvrant également au moins des premières parties des première et deuxième couches collectrices de charges 104, 108 disposées du côté des faces latérales 116 du substrat 102. La cellule 100 comporte également les premiers contacts électriquement conducteurs 124 disposés contre la première couche de TCO 118 et les deuxièmes contacts électriquement conducteurs 126 disposés contre la deuxième couche de TCO 122.

Enfin, la cellule 100 comporte un revêtement antireflet 128 recouvrant au moins des deuxièmes parties de la première couche collectrice de charges 104 et/ou de la deuxième couche collectrice de charges 108 disposées contre du côté des faces latérales 116 du substrat 102 et non recouvertes par la deuxième couche de TCO 122, et recouvrant également les bords 120 de la première face principale 112. Dans l'exemple de réalisation représenté sur la figure 7, le revêtement 128 recouvre également :
- la première couche de TCO 118 et les premiers contacts électriquement conducteurs 124 disposés contre la première couche de TCO 118, et
- la deuxième couche de TCO 122 et les deuxièmes contacts électriquement conducteurs 126 disposés contre la deuxième couche de TCO 122.

Toutefois, toutes les configurations précédemment décrites en lien avec les figures 1 à 6 peuvent s'appliquer à la cellule 100 de type tandem sur semi-conducteur.

Les différentes étapes mises en œuvre pour réaliser la cellule 100 peuvent être mises en œuvre de manière collective pour réaliser simultanément plusieurs cellules photovoltaïques.

Dans les exemples de réalisation précédemment décrits, le revêtement antireflet 128 est déposé sur la cellule 100 avant que celle-ci soit connectée électriquement à d'autres cellules photovoltaïques. En variante, il est possible que le revêtement antireflet 128 soit déposé sur plusieurs cellules photovoltaïques 100 qui sont déjà connectées électriquement les unes aux autres.

## Revendications

1. Cellule photovoltaïque (100) comprenant au moins :
- un ensemble comprenant au moins une jonction p-n incluant au moins un substrat (102) de semi-conducteur cristallin dopé selon un premier type de conductivité, des première et deuxième couches de passivation (106, 110) recouvrant respectivement des première et deuxième faces principales opposées du substrat (102) et chacune recouvrant également des faces latérales (116) du substrat (102), une première couche collectrice de charges (104) configurée pour extraire et collecter des charges du premier type de conductivité et disposée contre la première couche de passivation (106), et une deuxième couche collectrice de charges (108) configurée pour extraire et collecter des charges d'un deuxième type de conductivité, opposé au premier type de conductivité, et disposée contre la deuxième couche de passivation (110), ledit ensemble comprenant en outre une première face principale (112) disposée du côté de la première face principale du substrat (102) et une deuxième face principale (114) disposée du côté de la deuxième face principale du substrat (102) ;
- une première couche d'oxyde transparent conducteur (118) disposée contre une partie de la première face principale (112) de l'ensemble et telle que des bords (120) de la première face principale (112) de l'ensemble ne soient pas recouverts par la première couche d'oxyde transparent conducteur (118) ;
- une deuxième couche d'oxyde transparent conducteur (122) recouvrant la totalité de la deuxième face principale (114) de l'ensemble et recouvrant partiellement des premières parties de la première couche collectrice de charges (104) et/ou de la deuxième couche collectrice de charges (108) disposées du côté des faces latérales (116) du substrat (102) ;
- des contacts électriquement conducteurs (124, 126) disposés contre les première et deuxième couches d'oxyde transparent conducteur (118, 122) ;
- un revêtement antireflet (128) recouvrant au moins partiellement des deuxièmes parties de la première couche collectrice de charges (104) et/ou de la deuxième couche collectrice de charges (108) disposées du côté des faces latérales (116) du substrat (102) et non recouvertes par la deuxième couche d'oxyde transparent conducteur (122), et recouvrant également les bords (120) de la première face principale (112).

2. Cellule photovoltaïque (100) selon la revendication 1, dans lequel le revêtement antireflet (128) recouvre en outre la première couche d'oxyde transparent conducteur (118) et les contacts électriquement conducteurs (124) disposés contre la première couche d'oxyde transparent conducteur (118).

3. Cellule photovoltaïque (100) selon l'une des revendications précédentes, dans lequel le revêtement antireflet (128) est diélectrique et recouvre en outre au moins partiellement la deuxième couche d'oxyde transparent conducteur (122) et les contacts électriquement conducteurs (126) disposés contre la deuxième couche d'oxyde transparent conducteur (122).

4. Cellule photovoltaïque (100) selon l'une des revendications précédentes, dans lequel les bords (120) de la première face principale (112) forment, dans un plan parallèle à la première face principale (112), un contour de largeur inférieure ou égale à 500 µm.

5. Cellule photovoltaïque (100) selon l'une des revendications précédentes, dans lequel le revêtement antireflet (128) comporte au moins l'un des matériaux suivants : nitrure de silicium, oxyde de silicium, oxynitrure de silicium, oxyde de zinc dopé aluminium.

6. Cellule photovoltaïque (100) selon l'une des revendications précédentes, dans lequel le revêtement antireflet (128) comporte un indice de réfraction dont la valeur est comprise entre celle de l'indice de réfraction de la première couche d'oxyde transparent conducteur (118) et celle d'un matériau d'encapsulation de la cellule photovoltaïque (100).

7. Cellule photovoltaïque (100) selon l'une des revendications précédentes, dans lequel le revêtement antireflet (128) forme une couche d'épaisseur comprise entre 5 nm et 100 nm.

8. Cellule photovoltaïque (100) selon l'une des revendications précédentes, dans lequel le semi-conducteur du substrat (102) et des première et deuxième couches collectrices de charges (104, 108) comporte du silicium.

9. Cellule photovoltaïque (100) selon l'une des revendications précédentes, dans lequel :
- la cellule photovoltaïque (100) est une cellule à hétérojonction, et
- les première et deuxième couches de passivation (106, 110) comportent du semi-conducteur amorphe, ou nanocristallin, ou microcristallin, et non dopé intentionnellement, et
- les première et deuxième couches collectrices de charges (104, 108) comportent du semi-conducteur amorphe, ou nanocristallin, ou microcristallin, dopé.

10. Cellule photovoltaïque (100) selon l'une des revendications 1 à 8, dans lequel :
- la cellule photovoltaïque (100) est de type TOPCon, et
- les première et deuxième couches de passivation (106, 110) correspondent à des couches d'oxyde tunnel, et
- les première et deuxième couches collectrices de charges (104, 108) comportent du semi-conducteur polycristallin dopé.

11. Cellule photovoltaïque (100) selon l'une des revendications 1 à 8, dans lequel :
- la cellule photovoltaïque (100) est de type tandem sur semi-conducteur, et
- le substrat (102), les première et deuxième couches de passivation (106, 110) et les première et deuxième couches collectrices de charges (104, 108) forment une cellule inférieure de la cellule photovoltaïque (100), une face principale de la cellule inférieure formant la deuxième face principale dudit ensemble ;
- ledit ensemble comporte en outre une cellule supérieure disposée sur la cellule inférieure, une face principale de la cellule supérieure formant la première face principale dudit ensemble.

12. Cellule photovoltaïque (100) selon la revendication 11, dans lequel la cellule supérieure comporte au moins une couche de matériau de structure pérovskite.

13. Procédé de réalisation d'une cellule photovoltaïque (100), comportant la mise en œuvre des étapes suivantes :
- réalisation d'un ensemble comprenant au moins une jonction p-n incluant au moins un substrat (102) de semi-conducteur cristallin dopé selon un premier type de conductivité, des première et deuxième couches de passivation (106, 110) recouvrant respectivement des première et deuxième faces principales opposées du substrat (102) et chacune recouvrant également des faces latérales (116) du substrat (102), une première couche collectrice de charges (104) configurée pour extraire et collecter des charges du premier type de conductivité et disposée contre la première couche de passivation (106), et une deuxième couche collectrice de charges (108) configurée pour extraire et collecter des charges d'un deuxième type de conductivité, opposé au premier type de conductivité, et disposée contre la deuxième couche de passivation (110), ledit ensemble comprenant en outre une première face principale (112) disposée du côté de la première face principale du substrat (102) et une deuxième face principale (114) disposée du côté de la deuxième face principale du substrat (102) ;
- réalisation d'une première couche d'oxyde transparent conducteur (118) disposée contre une partie de la première face principale (112) de l'ensemble et telle que des bords (120) de la première face principale (112) de l'ensemble ne soient pas recouverts par la première couche d'oxyde transparent conducteur (118) ;
- réalisation d'une deuxième couche d'oxyde transparent conducteur (120) recouvrant la totalité de la deuxième face principale (114) de l'ensemble et recouvrant partiellement des premières parties de la première couche collectrice de charges (104) et/ou de la deuxième couche collectrice de charges (108) disposées du côté des faces latérales (116) du substrat (102) ;
- réalisation de contacts électriquement conducteurs (124, 126) disposés contre les première et deuxième couches d'oxyde transparent conducteur (118, 122) ;
- réalisation d'un revêtement antireflet (128) recouvrant au moins partiellement des deuxièmes parties de la première couche collectrice de charges (104) et/ou de la deuxième couche collectrice de charges (108) disposées du côté des faces latérales (116) du substrat (102) et non recouvertes par la deuxième couche d'oxyde transparent conducteur (122), et recouvrant également les bords (120) de la première face principale (112).

14. Procédé selon la revendication 13, dans lequel :
- les étapes du procédé forment plusieurs cellules photovoltaïques ;
- le procédé comporte en outre une étape d'interconnexion électrique des cellules photovoltaïques entre elles, mise en œuvre entre la réalisation des contacts électriquement conducteurs (124, 126) des cellules et la réalisation du revêtement antireflet (128).
